(19)

Europäisches
Patentamt
European
Patent Office
Office européen
des brevets

(11) **EP 2 498 082 A1**

(12) **EUROPEAN PATENT APPLICATION**
published in accordance with Art. 153(4) EPC

(43) Date of publication:
**12.09.2012 Bulletin 2012/37**

(21) Application number: **10827937.3**

(22) Date of filing: **15.10.2010**

(51) Int Cl.:
*G01N 27/30* [(2006.01)]     *C23C 14/34* [(2006.01)]

(86) International application number:
**PCT/ES2010/000418**

(87) International publication number:
**WO 2011/054982 (12.05.2011 Gazette 2011/19)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **05.11.2009 ES 200902118**

(71) Applicant: **Centro de Estudios e Investigaciones Tecnicas (CEIT) 20018 San Sebastian (Guipuzcoa) (ES)**

(72) Inventors:
- **AÑORGA GÓMEZ, Larraitz 20016 San Sebastian (Guipuzcoa) (ES)**
- **ARANA ALONSO, Sergio 20304 Irun (Guipuzcoa) (ES)**

(74) Representative: **Mendelsohn, Isabelle M. N. et al Cabinet Beau de Loménie 158, rue de l'Université 75340 Paris Cedex 07 (FR)**

(54) **THIN-FILM REFERENCE PSEUDO-ELECTRODE AND METHOD FOR THE PRODUCTION THEREOF**

(57) The present invention relates to a thin-film pseudo-reference electrode and method for the production thereof, wherein the pseudo-reference electrode (1) is made up of a substrate (2) formed by an oxidized silicon wafer, on which a single thin film of silver (3), which has a thickness comprised between 100 nm and 1500 nm, is deposited directly by means of the sputtering technique.

EP 2 498 082 A1

**Description**

Yield of the Art

The present invention relates to the production of reference electrodes by means of thin film deposition techniques, proposing to that end a thin-film silver (Ag) pseudo-reference electrode produced by means of the sputtering technique for the preferred application thereof in electrochemical biosensors.

State of the Art

Electrochemical biosensors are devices that are responsible for transforming chemical or biochemical information into an analytically useful and measurable signal; they are formed by a working electrode WE where the reaction of the element to be analyzed takes place, an auxiliary electrode or a counter electrode CE through which current flows, and a reference electrode RE used to measure the potential of the working electrode.

The measurement of the element to be analyzed is given by the potential difference established between the working electrode and the reference electrode, therefore having a reference electrode with a stable and well-defined electrochemical potential is indispensable for a correct measurement; conventional silver/silver chloride (Ag/AgCl) electrodes effectively comply with this criterion.

Biosensors for the electrochemical detection of DNA hybridization, which incorporate conventional Ag/AgCl reference electrodes, are known in the state of the art; however despite having every good stability, these reference electrodes have the drawback of being of a macroscopic scale, which is not compatible with the recent need to obtain increasingly smaller electrochemical biosensors in which the reference electrode is integrated directly in the biosensor next to the remaining electrodes.

In this aspect, miniaturized reference electrodes produced by means of thin-film deposition techniques are known, known as TFRE (Thin Film Reference Electrode), this is the case of United States patent US 4,933,048, or of the scientific publication by Maminska et al., "All-solid-state miniaturised planar reference electrodes based on ionic Liquids", Sens. Actuators B, 115, 552 (2006), disclosing a miniaturized reference electrode formed by a film of silver (Ag), another film of silver chloride (AgCl) and a solid electrolyte of potassium chloride (KCl), all being coated with a polymer membrane.

These solutions solve the problem of obtaining a miniaturized reference electrode integrated in the electrochemical biosensor, but, however, the process for the production thereof is complicated, requires a long time and high costs due to the large number of films from which it is formed; it is likewise not compatible with the standard processes carried out in foundries (where silicon chips are mass produced) because the production of these reference electrodes requires an electrochemical process to chlorinate the silver and obtain a film of silver chloride, which is not a standard process and would made it necessary to modify silicon chip mass production processes.

In turn, Chinese patent CN101216451, in the name of the Eastern University of Science and Technology of China, discloses a DNA biosensor likewise integrating a thick-film reference electrode produced by means of the screen-printing technique, however with this deposition technique, problems occur when very small electrode are required because with this technique a relatively thick film deposition, affecting the resolution of the biosensor is obtained.

A DNA biosensor integrating a thin-film reference electrode (TFRE) formed by a substrate consisting of a tin-doped indium oxide (ITO) wafer on which a layer of titanium is arranged as an adhesion element and a 100 nm film of silver is arranged on said layer is also known through the scientific publication by Cai et al., "Sequence-specific Electrochemical Recognition of Multiple Species using Nanoparticle Labels," Analytica Chimica Acta, 523(1) 61-68 (2004).

This solution has a slower production cost than the aforementioned solutions because the reference electrode is formed by fewer layers, however it does not solve the problem of mass production because tin-doped indium oxide (ITO) is not a standard substrate and therefore the production of this reference electrode would not be compatible with CMOS technology of standard silicon chip mass production processes. Also in the document by *Cai et al.*, no data is provided relating to the stability of the reference electrode, which is determined by the film of silver.

In view of the foregoing, it is necessary to provide thin-film reference electrodes with a stable electrochemical potential which are compatible with standard industrial production processes and allow mass production thereof.

Object of the Invention

According to the present invention, a pseudo-reference electrode integrable in an electrochemical biosensor is proposed, more specifically, the objective of the invention is the production of an electrochemical biosensor integrating a miniaturized pseudo-reference electrode produced by means of a thin film deposition technique, specifically by sputtering, such that a stable pseudo-reference electrode is obtained with a production process that is simpler than those known until now and that allows mass production thereof.

The pseudo-reference electrode object of the invention is made up of a substrate formed by an oxidized silicon wafer on which a single thin film of silver is deposited directly by means of the sputtering technique, which thin film of silver, has a thickness comprised between 100 nm and 1500 nm, preferably the thickness of the thin film of silver is 1000 nm.

To improve adhesion between the substrate formed by the oxidized silicon wafer and the thin film of silver, the placement of a layer of adhesive material, preferably a layer of chromium, is provided, although it could also be another compound providing the necessary adhesion.

Although silicon is currently a substrate compatible with standard industrial production processes, the features of the pseudo-reference electrode object of the invention would not be altered in the event of using another material as a layer of substrate, provided that such material was compatible with the current standard industrial production processes; therefore the layer of substrate on which the thin film of silver is deposited directly could be formed by another type of wafer, such as an alumina or glass wafer for example.

The method carried out for producing the pseudo-reference electrode object of the invention is based on the direct deposition of a single thin film of silver on the substrate formed by the oxidized silicon, alumina or glass wafer, using for that purpose the conventional sputtering technique, which allows obtaining thin films in a simple and effective manner.

A miniaturized thin-film silver pseudo-reference electrode allowing direct integration in an electrochemical biosensor is thereby obtained, and it has good stability, being compatible with CMOS technology and also allowing standardization and therefore mass production thereof within standard industrial production processes.

Description of the Drawing

Figure 1 is a graphic representation of a conventional miniaturized Ag/AgCl reference electrode according to the known technique.

Figure 2 is a graphic representation of the pseudo-reference electrode object of the invention.

Figure 2A is an embodiment of the pseudo-reference electrode in which a layer of adhesive material is arranged between the substrate and the thin film of silver.

Figure 3 shows a diagram of an electrochemical biosensor in which the pseudo-reference electrode object of the invention is integrated.

Figures 4A to 4J show the production sequence for the electrochemical biosensor of the preceding figure.

Figure 5 shows the cyclic voltammograms obtained by comparing the pseudo-reference electrode and a commercial Ag/AgCl reference electrode of a macroscopic scale.

Figure 6 shows a graph where the stability of the pseudo-reference electrode throughout a one-month testing period is verified.

Detailed Description of the Invention

The object of the invention relates to a thin-film silver pseudo-reference electrode produced by means of sputtering technology, which is integrable in an electrochemical biosensor such that a compact, portable device compatible with CMOS technology and allowing the mass production thereof is obtained.

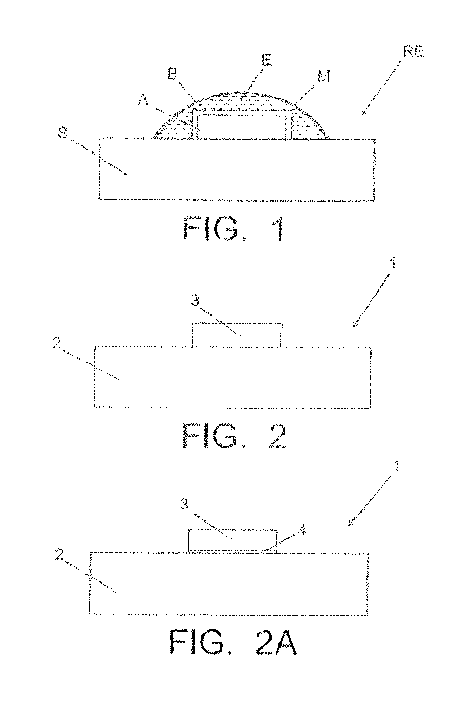

Figure 1 depicts a miniaturized Ag/AgCl reference electrode according to the known technique, in which the reference electrode (RE) is formed by a substrate (S) on which a series of films are deposited, i.e., a film of silver (A), which undergoes an electrochemical process of chlorination to form thereon a film of silver chloride (B), then a potassium chloride electrolyte (E) is deposited and finally it is all coated with a polymer membrane (M).

Figure 2 shows the pseudo-reference electrode (1) object of the invention which is made up of a substrate (2) formed by an oxidized silicon wafer, on which a single thin film of silver (3) is deposited directly by means of the sputtering technique., which thin film of silver has a thickness comprised between 100 nm and 1500 nm, preferably the thickness of the thin film of silver (3) is 1000 nm.

Figure 2A shows an embodiment of the pseudo-reference electrode (1), wherein to improve adhesion between the substrate (2) formed by the oxidized silicon wafer and the thin film of silver (3), the placement of a layer (4) of adhesive material, preferably a layer of chromium, is provided, the operating characteristics of the device not being altered by incorporating this layer.

The method carried out for producing the pseudo-reference electrode (1) is based on the direct deposition of a single thin film of silver (3) on the substrate (2) formed by the oxidized silicon, alumina or glass wafer, using for that purpose the known sputtering deposition technique.

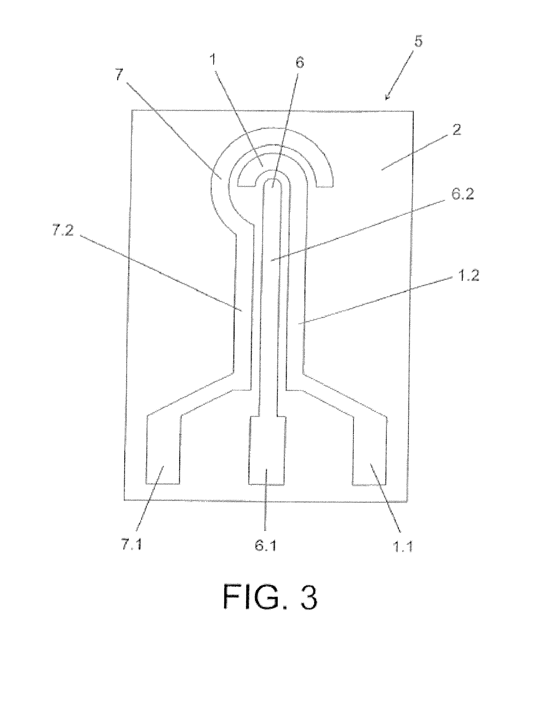

Figure 3 shows an electrochemical biosensor (5) in which the pseudo-reference electrode (1) object of the invention is integrated directly, therefore the electrochemical biosensor (5) is formed by a working electrode (6) formed by a gold disc of the order of 100 nm in thickness and 350 microns of diameter deposited by RF sputtering, a counter electrode (7) or an auxiliary electrode formed by a platinum semicircle of the order of 200 nm in thickness deposited by DC sputtering and the pseudo-reference electrode (1) formed by a silver semicircle of between 100 nm and 1500 nm in thickness, preferably 1000 nm in thickness, also deposited by DC sputtering.

Gold, platinum and silver, constituents of the working electrode (6), of the counter electrode (7) and of the pseudo-reference electrode (1), respectively, are deposited directly on the substrate (2) formed by an oxidized silicon wafer; the arrangement of a layer (4) of adhesive material, such as chromium, between the films of gold, platinum and silver and the oxidized silicon wafer has likewise been provided.

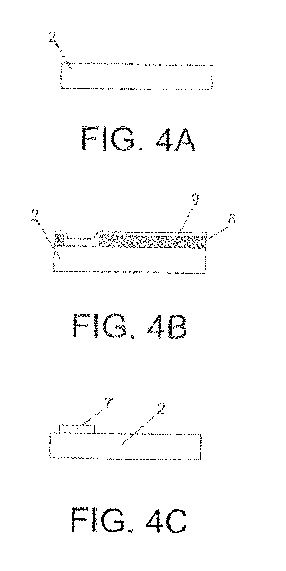

Figures 4A to 4J show the process carried out for producing the electrochemical biosensor (5), in which the techniques used (sputtering, photolithography and PECVD (plasma-enhanced chemical vapor deposition)) are common in the technology of the silicon chip production industry. The photolithographic process uses a resin (8) for processing which, like sputtering and PECVD, is conventional and known by a person skilled in the art so the working thereof will not be described.

The geometry of the counter electrode (7), of the pads (7.1, 6.1, 1.1) and of the tracks (7.2, 6.2, 1.2), which are observed in Figure 3, are therefore first defined on the substrate (2) formed by an oxidized silicon wafer (Figure 4A) by means of a photolithographic process, a film of platinum (9) is subsequently (Figure 4B and 4C) deposited by means of the DC sputtering technique, and the resin (8) and the material deposited on the resin (8) are removed by means of a lift-off process, thereby obtaining the counter electrode (7), the pads (7.1, 6.1, 1.1) and the tracks (7.2, 6.2, 1.2).

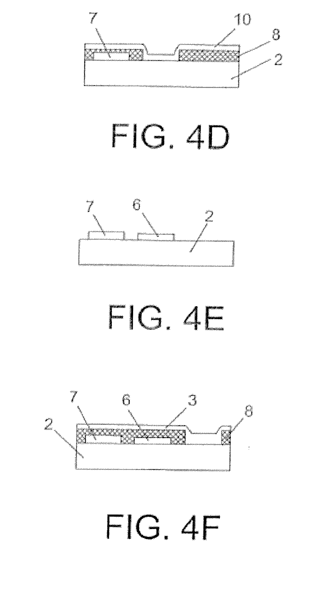

Likewise, the geometry of the working electrode (6) is then defined by means of another photolithographic process, a film of gold (10) is deposited by means of the RF sputtering technique, and a lift-off process is performed to remove the resin (8) and the gold deposited thereon (Figures 4D and 4E).

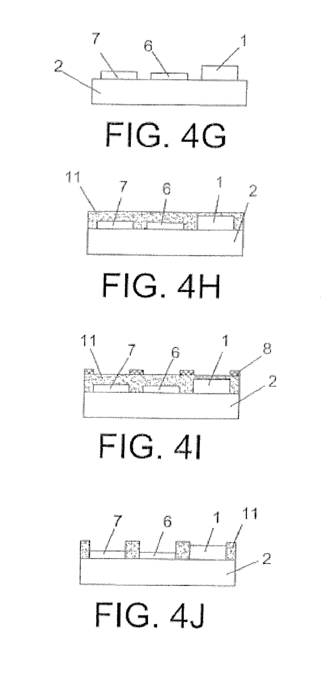

Next, the geometry of the pseudo-reference electrode (1) is defined by means of another photolithographic process, a thin film of silver (3) is deposited by means of the DC sputtering technique, and the resin (8) and the material deposited thereon are removed by means of a lift-off process (Figures 4F and 4G).

An intermediate layer of chromium can be used in all deposits to improve adherence between the deposited films (3,9,10) and the substrate (2).

Finally, for the purpose of passivating the inactive areas of the biosensor, a layer of silicon dioxide (11) is deposited by means of PECVD by chemical etching in the working electrode (6), in the counter electrode (7), and in the pseudo-reference electrode (1). The other parts are protected from etching with a photoresist resin (8) which has previously been deposited by means of a photolithographic process and is removed by means of a lift-off process after chemical etching (Figures 4H, 4I and 4J).

The results obtained by comparing microdevices, i.e., electrochemical biosensors, in which the pseudo-reference electrode object of the invention (hereinafter referred to as TFRE) is integrated, and an electrochemical biosensor with a commercial Ag/AgCl reference electrode of a macroscopic scale are shown below. All the experiments are performed in a clean room at room temperature.

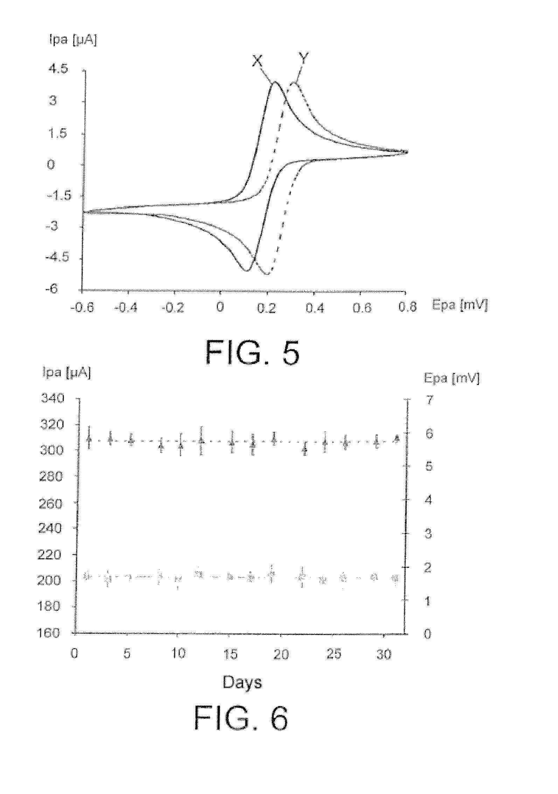

The developed microdevices were characterized in a 25 mM solution of potassium ferrocyanide (K3Fe(CN)6) using the silver TFRE and a commercial Ag/AgCl reference electrode. The obtained results are shown in Figure 5, where it can be seen that the cyclic voltammogram obtained as a mean of six microdevices measured with the developed TFRE (X) and the cyclic voltammogram of the commercial Ag/AgCl reference electrode (Y) have almost the same shape, showing well-defined oxidation-reduction corresponding to the potassium ferricyanide/ferrocyanide redox couple.

The intensity of the current peaks is almost the same in both cases:

$$I_{pa\ Ag\ TFRE} = 5.83 \pm 0.33\ \mu A;$$

$$I_{pa\ Ag\ /\ AgCl\ RE} = 5.80 \pm 0.39\ \mu A;$$

(mean value and standard deviation of 6 electrodes); whereas a difference of 81 mV occurs in the potential of the peaks:

$$Epa_{Ag\ TFRE} = 205 \pm 3\ mV;$$

$$Epa_{Ag\ /\ AgCl\ RE} = 286 \pm 1\ mV;$$

(mean value and standard deviation of 6 electrodes).

The fact that similar current peak values are obtained with both reference electrodes shows that the sensitivity of the microdevice is the same When a commercial Ag/AgCl reference electrodes or the developed silver TFRE is used.

The studied microdevices further showed good reproducibility. The cyclic voltammograms obtained for the devices that have been measured using the silver TFRE are almost the same, showing virtually the same current and potential peak values

$$I_{pa\ Ag\ TFRE} = 5.83 \pm 0.33\ \mu A;$$

$$Epa_{Ag\ TFRE} = 205 \pm 3\ mV,\ n = 6;$$

which range between 5.44 $\mu A$ and 6.40 $\mu A$, and 201 mV and 208 mV, respectively. These variations in potentials could be due to the sputtering process in which the thickness of the layer of silver may vary from one side of the wafer, to the other in a range of 1 micron to 850 nm.

It is well known that one of the main problems with the reference electrodes is the stability of the potential thereof over time. To check stability of the developed silver TFRE, the electrochemical behavior thereof has been studied for more than a month.

Durante this time, the anode/cathode potential peaks and the current peaks obtained from the cyclic voltammogram have been periodically verified every two days. After each measurement, the electrodes were rinsed with Milli Q™ water, dried with a nitrogen stream and kept in nitrogen-free oxygen atmosphere (99.99%).

Figure 6 shows the mean values and standard deviations of 5 microdevices that have been measured during this time period; the intensity of the current peaks ($I_{pa}$) is shown by the dotted line and the potential (Epa) is shown by the solid line. As can be seen, the response obtained during the sampling time period remains almost linear:

$$Epa = 208 \pm 6\ mV,\ I_{pa} = 5.7 \pm 0.20\ \mu A;$$

(mean value standard deviation of 5 microdevices).

The differences obtained (on the same day) in the potential and current peak values are due to the different sensors used in the study which, as mentioned above, are not identical due to the sputtering process.

The following table shows the mean potential value (Epa), the mean current peak value ($I_{pa}$) and the maximum difference obtained in the potential peak and current peak values of each electrode. In the worst case (chips 4 and 5) the maximum difference in the potential peak and current peak are 14 mV and 0.80 $\mu A$, respectively, and in the best case, 5 mV and 0.31 $\mu A$ (chip 3).

| Chip | Epa (mV) | Max. difference Epa (mV) | $I_{pa}$ $\mu A$ | Max. difference $I_{pa}$ $\mu A$ |
|---|---|---|---|---|
| 1 | 210±3 | 12 | 5.5±0.2 | 0.68 |
| 2 | 211±2 | 7 | 5.49±0.14 | 0.47 |
| 3 | 200±2 | 5 | 5.87±0.1 | 0.31 |
| 4 | 201±5 | 14 | 5.69±0.2 | 0.68 |
| 5 | 216±5 | 14 | 6.07±0.21 | 0.8 |

Reports on long-term stability of TFREs made by the sputtering technique are not known. In any case, based on the preceding results it can be concluded that the proposed pseudo-reference electrode is stable over time.

**Claims**

1. A thin-film pseudo-reference electrode integrable in an electrochemical biosensor comprising a working electrode, an auxiliary electrode or a counter electrode and a reference electrode, **characterized in that** the pseudo-reference electrode (1) is made up of a substrate (2) formed by an oxidized silicon wafer on which a single thin film of silver (3), 1;hitch has a thickness comprised between 100 nm and 1500 nm, is deposited directly.

2. The thin-film pseudo-reference electrode according to claim 1, **characterized in that** the thin film of silver (3) has a thickness of 1000 nm.

3. The thin-film pseudo-reference electrode according to claim 1, **characterized in that** a layer (4) of adhesive material is arranged between the substrate (2) formed by the oxidized silicon wafer and the thin film of silver (3).

4. The thin-film pseudo-reference electrode according to claim 3, **characterized in that** the layer (4) of adhesive material is a layer of chromium.

5. The thin-film pseudo-reference electrode according to claim 1, **characterized in that** the substrate (2) is an alumina wafer or a glass wafer.

6. A method for producing the thin-film pseudo-reference electrode of claim 1, **characterized in that** a single thin film of silver (3) is deposited directly on a substrate (2) formed by an oxidized silicon, alumina or glass wafer by means of the sputtering technique.

FIG. 1

FIG. 2

FIG. 2A

FIG. 3

FIG. 4A

FIG. 4B

FIG. 4C

FIG. 4D

FIG. 4E

FIG. 4F

FIG. 4G

FIG. 4H

FIG. 4I

FIG. 4J

FIG. 5

FIG. 6

# INTERNATIONAL SEARCH REPORT

| | |
|---|---|
| International application No. | |
| PCT/ES2010/000418 | |

**A. CLASSIFICATION OF SUBJECT MATTER**

*G01N27/30* (2006.01)
*C23C14/34* (2006.01)
According to International Patent Classification (IPC) or to both national classification and IPC

**B. FIELDS SEARCHED**

Minimum documentation searched (classification system followed by classification symbols)
G01N, C23C

Documentation searched other than minimum documentation to the extent that such documents are included in the fields searched

Electronic data base consulted during the international search (name of data base and, where practicable, search terms used)

EPODOC, INVENES, WPI, XPESP, NPL, CAPLUS

**C. DOCUMENTS CONSIDERED TO BE RELEVANT**

| Category* | Citation of document, with indication, where appropriate, of the relevant passages | Relevant to claim No. |
|---|---|---|
| A | DELGADO, J.M., et al., A comparison between chemical and sputtering methods for preparing thin-film silver electrodes for in situ ATR-SEIRAS studies. Electrochimica Acta, 2007, vol.52, págs.4605-4613. Abstract. | 1-6 |
| A | OATES, T.W.H., eta al., Accurate determination of optical and electronic properties of ultra-thin silver films for biosensor applications, Sensors and Actuators B, 2005, Vol.109, págs.146-152. Abstract. | 1-6 |
| A | SABRI, Y.M., et al., Mercury diffusion in gold and silver thin film electrodes on quartz crystal microbalance sensors, Sensors and Actuators B, 2009, Vol.137, págs.246-252. Abstract. | 1-6 |

☒ Further documents are listed in the continuation of Box C.  ☐ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance. | |
| "E" earlier document but published on or after the international filing date | |
| "L" document which may throw doubts on priority claim(s) or which is cited to establish the publication date of another citation or other special reason (as specified) | "X" document of particular relevance; the claimed invention cannot be considered novel or cannot be considered to involve an inventive step when the document is taken alone |
| "O" document referring to an oral disclosure use, exhibition, or other means. | "Y" document of particular relevance; the claimed invention cannot be considered to involve an inventive step when the document is combined with one or more other documents , such combination being obvious to a person skilled in the art |
| "P" document published prior to the international filing date but later than the priority date claimed | |
| | "&" document member of the same patent family |

| Date of the actual completion of the international search | Date of mailing of the international search report |
|---|---|
| 18/03/2011 | **(23/03/2011)** |

| Name and mailing address of the ISA/ | Authorized officer |
|---|---|
| OFICINA ESPAÑOLA DE PATENTES Y MARCAS Paseo de la Castellana, 75 - 28071 Madrid (España) Facsimile No.: 91 349 53 04 | M. García Poza |
| | Telephone No. 91 3495568 |

Form PCT/ISA/210 (second sheet) (July 2009)

## INTERNATIONAL SEARCH REPORT

International application No.

PCT/ES2010/000418

| C (continuation). | DOCUMENTS CONSIDERED TO BE RELEVANT | |
|---|---|---|
| Category * | Citation of documents, with indication, where appropriate, of the relevant passages | Relevant to claim No. |
| A | HANEWINKEL, C., et al., Adsorption of metal cations precisely quantified by surface resistance of thin epitaxial silver film electrodes, Electrochimica Acta, 1997, vol.42, págs.3345-3349. Abstract. | 1-6 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4933048 A

- CN 101216451

**Non-patent literature cited in the description**

- **Maminska et al.** All-solid-state miniaturised planar reference electrodes based on ionic Liquids. *Sens. Actuators B,* 2006, vol. 115, 552

- **Cai et al.** Sequence-specific Electrochemical Recognition of Multiple Species using Nanoparticle Labels. *Analytica Chimica Acta,* 2004, vol. 523 (1), 61-68